# EUROPÄISCHE PATENTSCHRIFT

(11) **EP 3 252 783 B1**
(45) Veröffentlichungstag und Bekanntmachung des Hinweises auf die Patenterteilung: **27.11.2019**
(21) Anmeldenummer: 17169526.5
(22) Anmeldetag: 04.05.2017
(51) Int. Cl.: H01F 6/06

(54) **MAGNETANORDNUNG MIT FELDFORMELEMENT ZUR REDUKTION DER RADIALEN FELDKOMPONENTE IM BEREICH EINER HTS SEKTION**
MAGNET ASSEMBLY WITH FIELD SHAPING ELEMENT FOR REDUCING THE RADIAL FIELD COMPONENTS IN THE REGION OF A HTS SECTION
ENSEMBLE D'AIMANTS COMPRENANT UN ÉLÉMENT DE FORMATION DE CHAMP DESTINÉ À RÉDUIRE LES COMPOSANTS DE CHAMP RADIAUX DANS LA ZONE D'UNE SECTION HTS

(30) Priorität: 12.05.2016 DE 102016208225
(43) Veröffentlichungstag der Anmeldung: 06.12.2017
(73) Patentinhaber: Bruker BioSpin GmbH, 76287 Rheinstetten (DE)
(72) Erfinder: WIKUS, Patrick, 8309 Nürensdorf (CH); NIEMANN, Volker, 75228 Ispringen (DE); FRANTZ, Wolfgang, 76137 Karlsruhe (DE); DUMM, Michael, 8050 Zürich (CH); WAGENKNECHT, Michael, 8050 Zürich (CH)
(74) Vertreter: Kohler Schmid Möbus Patentanwälte

(56) Entgegenhaltungen:
- WO-A2-96/08830
- DE-B3-102012 215 507
- J PITEL ET AL: "Compensation of the radial magnetic field component of solenoids wound with anisotropic Bi(2223)Ag tape", SUPERCONDUCTOR SCIENCE AND TECHNOLOGY., Bd. 10, Nr. 11, 1. November 1997 (1997-11-01), Seiten 847-852, XP055417645, GB ISSN: 0953-2048, DOI: 10.1088/0953-2048/10/11/010

## Beschreibung

Die Erfindung betrifft eine längs einer Axialrichtung aufgebaute supraleitfähige Magnetspulenanordnung mit mindestens einer solenoidförmigen Spulensektion, die mit einem HTS(=Hochtemperatursupraleiter)-Bandleiter gewickelt ist, sowie mit einer mindestens zwei Feldformelemente umfassenden Feldformvorrichtung.

Eine solche Magnetspulenanordnung ist beispielsweise bekannt aus DE 10 2013 220 142 A1 oder JP 2001-264402 A.

### Hintergrund der Erfindung

Supraleitende NMR Magnete werden üblicherweise aus NbTi oder Nb3Sn Drähten gefertigt. Aufgrund der Beschränkung, die das kritische Magnetfeld von Nb3Sn verursacht, ergibt sich derzeit eine obere Grenze von etwa 23,5T für die maximal erreichbare Feldstärke. Dies entspricht in der NMR einer Protonenresonanzfrequenz von 1000MHz.

Um höhere Feldstärken zu erreichen und/oder um einen Magnet gegebener Feldstärke kompakter gestalten zu können, muss auf alternative Leitermaterialien zurückgegriffen werden. Erforscht wird in diesem Zusammenhang derzeit hauptsächlich der Einsatz von HTS Bandleitern (z. B. ReBCO, BSCCO oder Eisen-Pniktide). Dabei wird der Magnet nicht komplett aus HTS Materialien gefertigt. Aus Kostengründen ist es vielmehr vorteilhaft, nur für die innersten Sektionen HTS Material zu verwenden, und den Hintergrundmagneten in konventioneller "Low-Temperature-Superconductor" (LTS) Technologie (also mit NbTi und/oder Nb3Sn) zu fertigen.

Üblicherweise wird eine Magnetsektion aus HTS Bandmaterial gewickelt, und dann mit einem LTS Hintergrundmagnet in Serie geschaltet. Die Stromtragfähigkeit von HTS Bandleitern (bzw. deren "kritischer Strom" I_{c}) hängt nicht nur von der Stärke des Magnetfelds ab, in dem sich der Leiter befindet, sondern auch von der Orientierung des Feldes. Verlaufen die Feldlinien parallel zur Oberfläche des Bandes, ist der kritische Strom I_{C} hoch; verlaufen die Feldlinien in einem Winkel zur Oberfläche des Bandes, sinkt I_{C} mit zunehmendem Winkel ab.

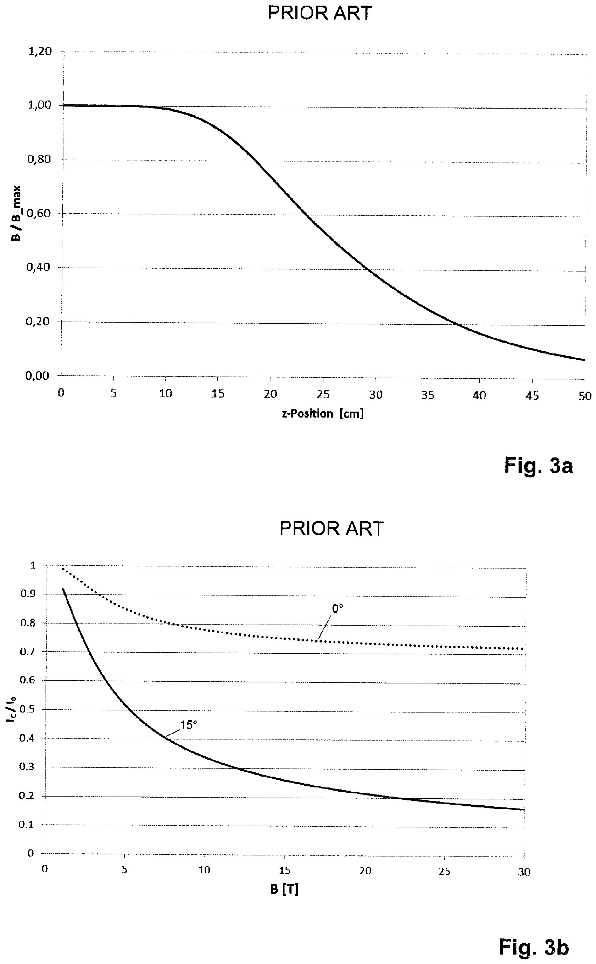

In einem NMR Magnet, der im Allgemeinen aus solenoidförmigen Spulensektionen aufgebaut ist, verlaufen die Feldlinien im Zentrum der Spulensektionen parallel zur Achse des Magneten. Zum Rand der solenoidförmigen Spulensektionen hin nimmt die radiale Komponente des Felds zu (siehe Fig. 3a). Hier ist die I_{C}-Auslastung des HTS-Leiters demnach am höchsten.

Die Stromzuleitungen zur HTS Sektion müssen ebenfalls durch einen Bereich geführt werden, in dem hohe radiale Feldkomponenten herrschen. Die Führung des Leiters erfolgt typischerweise entlang eines komplex geformten Pfades, so dass sichergestellt wird, dass der Winkel zwischen HTS-Band und Feldlinie minimal ist.

### Spezieller Stand der Technik

In DE 102 60 728 A1 wird ein Verfahren vorgestellt für den idealen Verlauf eines HTS Bandleiters, wie er aus einer Spulenwicklung in einem vorgegebenen Pfad herausgeführt wird. Die zugrunde liegende Problematik ist hier, dass das HTS Band einem gekrümmten Feld ausgesetzt ist.

Die eingangs zitierte DE 10 2013 220 142 A1 offenbart eine gattungsgemäße Magnetanordnung mit einem HTS-Bandleiter und einem LTS Draht, die elektrisch in Serie geschaltet sind mittels eines Joints. Die HTS-Spule bildet hierbei die innere Sektion der koaxial angeordneten Spulen. Der Joint befindet sich außerhalb des parallelen B0-Feldes, wo das Magnetfeld eine deutlich radiale Komponente aufweist. Aufgrund der Geometrie des HTS-Bandleiters, ist der Verlauf des HTS Bandes dem lokalen Winkel des Magnetfeldes angepasst, so dass die Bandebene und die Feldlinien parallel zueinander ausgerichtet sind und die Stromtragfähigkeit des HTS Bandes optimiert wird. Allerdings wird hier nicht thematisiert oder gar aufgezeigt, inwiefern das B0-Feld an den Randbereichen der Solenoidwicklung beeinflusst werden kann, um eine Radialkomponente am HTS Bandleiter zu minimieren.

Die ebenfalls eingangs zitierte JP 2001-264402 A offenbart eine supraleitende Magnetanordnung, die ebenfalls aus mehreren koaxial angeordneten Solenoid-Magneten aufgebaut ist. Die innere Spule ist aus einem HTS Material hergestellt. Ziel des Magnetaufbaus ist es, ein besonders homogenes Magnetfeld bereitzustellen. Hierfür werden auch sogenannte correction coils 3a-3c aus supraleitendem Material außerhalb der Hauptspulensektionen angeordnet, deren Aufgabe darin besteht, das Feld eben zu homogenisieren. Kein Thema in diesem Dokument ist jedoch die Problematik am Randbereich des HTS Bandleiters. Dies ist auch daraus zu erkennen, dass die Korrekturspulen nicht am Randbereich angeordnet sind. Des Weiteren liegen hier die Korrekturspulen so weit außen, dass sie nicht besonders effizient sind.

Die gegenwärtig im Stand der Technik eingesetzten Lösungen weisen mehrere Nachteile auf:
- Die an den Leiter gestellte I_{C} Anforderung werden durch die Teile der HTS Sektion, die großen radialen Feldkomponenten ausgesetzt ist, bestimmt (üblicherweise am Rand der solenoidförmigen HTS Sektion - dort ist der Leiter am höchsten ausgelastet). Die resultierenden hohen Anforderungen wirken sich negativ auf Leiterpreis und dessen kommerzielle Verfügbarkeit aus.
- Die Führung des Leiters vom und zum Wickelpaket erfolgt entlang eines komplex geformten Pfades (siehe etwa DE 102 60 728 A1), was aufwendig und platzintensiv ist.
- In den Bereichen der HTS Sektion, die großen radialen Feldkomponenten ausgesetzt sind, bilden sich in den HTS-Bandleitern Abschirmströme ("screening currents"), die ihrerseits das Magnetfeld beeinflussen und (insbesondere bei der NMR hochgradig unerwünschte) Inhomogenitäten hervorrufen.

### Aufgabe der Erfindung

Der vorliegenden Erfindung liegt demgegenüber die Aufgabe zugrunde, eine supraleitfähige Magnetspulenanordnung der eingangs definierten Art sowie ein Verfahren zu deren Design mit möglichst einfachen, allgemein zur Verfügung stehenden technischen Mitteln so zu modifizieren, dass die oben diskutierten Einschränkungen von derartigen supraleitfähigen Magnetspulenanordnungen, welche typischerweise an den axialen Enden der HTS Sektion auftreten, deutlich abgemildert oder möglichst gänzlich vermieden werden, und dass die mit der Spule erzeugbare Magnetfeldstärke erheblich erhöht wird, wobei die Magnetspulenanordnung besonders kompakt gestaltbar sein soll.

### Kurze Beschreibung der Erfindung

Diese Aufgabe wird auf ebenso überraschend einfache wie wirkungsvolle Weise sowie mit ohne Weiteres zur Verfügung stehenden technischen Mitteln durch eine supraleitfähige Magnetspulenanordnung nach Anspruch 1 gelöst.

### Wirkungsweise der Erfindung und weitere Vorteile gegenüber dem Stand der Technik

Unter gewissen Umständen ist die Stromtragfähigkeit von Spulen, die aus anisotropem Supraleiter gewickelt sind, an den axialen Enden durch die Magnetfeldkomponente in radialer Richtung limitiert. Die vorliegende Erfindung schlägt eine supraleitfähige Magnetspulenanordnung mit speziell ausgestalteten Feldformelementen vor, welche es ermöglichen, die Stromtragfähigkeit der Spule zu erhöhen.

Die Stromtragfähigkeit des Supraleiters an den axialen Spulenenden wird erhöht, indem axial oberhalb und unterhalb der solenoidförmigen HTS-Spule Feldformelemente angeordnet sind, die den Feldwinkel des Magnetfelds bezüglich der Axialrichtung im Bereich der HTS-Sektion entscheidend verkleinern.

Dadurch wird die radiale Feldkomponente, die auf den HTS Bandleiter wirkt, verringert. Das hat mehrere Vorteile:
Der kritische Strom eines HTS Bandes hängt nicht nur von der Temperatur und vom Feld ab, sondern auch vom Feldwinkel. Wenn der Feldwinkel kleiner wird, steigt der kritische Strom (siehe Fig. 3b). Man kann also entweder stärkere Magnete bauen oder kostengünstigeres Leitermaterial verwenden.

Die radiale Feldkomponente erzeugt im HTS Abschirmströme, die wiederum auf das Feld im Probenvolumen zurückwirken und Inhomogenitäten hervorrufen. Mit Hilfe der Erfindung können diese zusätzlichen Feldinhomogenitäten vermieden werden.

Ein weiterer Vorteil der erfindungsgemäßen Anordnung besteht in der gleichmäßigeren Verteilung der Stromtragfähigkeit des Supraleiters in der gesamten Spule. Dadurch wird der Supraleiter für den Stromfluss besser ausgenutzt, die Spule kann bei einem höheren Strom betrieben werden. Die benötigte Qualität des HTS Leiters (insbesondere in Hinsicht auf Ic) und/oder - menge und somit die Herstellungskosten sind folglich geringer als bei vergleichbaren herkömmlichen Anordnungen. Andererseits kann mit derselben Supraleiterqualität und/oder -menge ein höheres Magnetfeld im Spulenzentrum erzeugt werden.

Dies alles kann erfindungsgemäß durch geeignet ausgebildete Feldformelemente aus Wicklungen aus LTS-Material erreicht werden.

Der gesamte Magnet kann dann so konstruiert werden, dass derartige LTS Feldform-Windungen in einem Bereich liegen, in dem die radiale Feldkomponente hoch, der absolute Feldbetrag aber unterhalb des kritischen Felds des eingesetzten LTS Leiters ist.

Im Bereich der HTS Sektion, wo das Hintergrundfeld so groß ist, dass nur HTS-Material eingesetzt werden kann, bleiben die Radialkomponenten klein. Dort, wo die Radialkomponenten des Hintergrundfelds groß werden, ist das Feld betragsmäßig klein genug, so dass auf LTS-Materialien zurückgegriffen werden kann.

### Bevorzugte Ausführungsformen und Weiterbildungen der Erfindung

Bei einer ersten Klasse von Beispielen der Magnetspulenanordnung umfasst die Feldformvorrichtung Feldformelemente, welche aus einem magnetischen Material, insbesondere aus ferromagnetischem Material wie etwa Eisen, aufgebaut sind. Wenn die Feldformelemente passiv, also nicht-stromdurchflossen sind, können sie besonders einfach und preisgünstig realisiert werden.

Besonders bevorzugt sind auch Ausführungsformen der Erfindung, bei denen das Längenverhältnis der HTS-Spulensektion zu einem Feldformelement zwischen 1:2 und 1:5 beträgt. Simulationen haben ergeben, dass dieses Längenverhältnis in Hochfeldmagneten zu einem besonders effizienten Design führt.

Weitere vorteilhafte Ausführungsformen der erfindungsgemäßen Magnetspulenanordnung zeichnen sich dadurch aus, dass die HTS-Spulensektion von den Feldformelementen durch einen oder mehrere Flansche räumlich getrennt ist, deren Dicke vorzugsweise zwischen 2mm und 10mm beträgt. Die Kräfte im Magnet wirken so, dass Solenoide entlang ihrer Achse zusammengedrückt werden (= "axialer Druck"). Die Flansche können die Kräfte aufnehmen, mit denen die Feldformelemente in Richtung Zentrum gedrückt werden, und entlasten so die HTS-Wicklung. Außerdem helfen die Flansche zusätzlich, da die Feldformelemente aus LTS- Leiter aufgebaut sind: Dann bilden sie nämlich die Begrenzung für die Wickelkammern.

Vorzugsweise beträgt die maximale Feldstärke am magnetischen Zentrum der Magnetspulenanordnung mindestens 27T. Eine Feldstärke von 20T entspricht in etwa einem 850MHz-Magneten. Aufgrund der -derzeitigen- Marksituation rechnet sich ab etwa dieser Frequenz der Einsatz von HTS-Bändern, und zwar vor allem deswegen, um Magnetdesigns günstig von der 2K Technologie auf 4K Technologie portieren zu können. Die vorliegende Erfindung trägt daher wesentlich dazu bei, einen Höchstfeldmagneten bereitzustellen, wie es ihn bisher noch nicht gibt. Eine solche Höchstfeldmagnetanordnung umfasst dann als innerste Spule einen HTS-Bandleiter, um den Feldhub auf beispielsweise 1,2GHz zu bringen. Ein bisher erheblicher Schwachpunkt bei einer Technologie, die HTS-Bandleiter einsetzt, sind die radialen Magnetfelder, welche die Stromtragfähigkeit reduzieren. Um daher diese Radialkomponenten "geradezubiegen", werden erfindungsgemäß randständige Feldformelemente vorgeschlagen, die entweder aus LTS-Material oder aus Eisenstrukturen hergestellt sind.

Beansprucht ist eine Klasse von Ausführungsformen der erfindungsgemäßen Spulenanordnung, bei denen die Feldformvorrichtung Feldformelemente umfasst, welche mindestens eine mit einem LTS(=Tieftemperatursupraleiter)-Draht gewickelte LTS-Spulensektion enthalten.

Mit LTS-Drähten lassen sich nämlich hohe Stromdichten erreichen, ohne dass der Feldwinkel einen schädlichen Einfluss auf den kritischen Strom I_{C} hat. Mit stromdurchflossenen LTS-Leitern können besonders effiziente Feldformelemente realisiert werden.

Vorteilhafte Weiterbildungen dieser Klasse von Ausführungsformen sind dadurch gekennzeichnet, dass die LTS-Spulensektionen der Feldformvorrichtung mit den HTS-Spulensektionen elektrisch verbunden, insbesondere in Serie geschaltet sind, wobei der HTS-Bandleiter und der LTS-Draht durch einen Joint verbunden sind. Wenn die LTS-Elemente mit den HTS- Elementen elektrisch in Serie verbunden sind, ist sichergestellt, dass durch diese Magnetsektionen exakt der gleiche Strom fließt. Dadurch ist ausgeschlossen, dass sich in der Hauptspule und in den Feldformelementen z.B. durch induktive Effekte unterschiedliche Ströme ausbilden. Das hilft bei vielen Dingen, z.B. beim Aufrechterhalten der Homogenität über lange Zeit, oder in Bezug auf die Quench-Sicherheit.

Bei bevorzugten Weiterbildungen enthält der LTS-Draht eine Legierung mit, insbesondere aus, den Elementen Nb und Sn. Nb3Sn ist ein sehr leistungsfähiger LTS Supraleiter, mit dem sich außergewöhnlich hohe Stromdichten erreichen lassen. Übertroffen wird er darin nur durch HTS-Material.

Vorzugsweise sind die Feldformelemente axial so nahe am magnetischen Zentrum der Magnetspulenanordnung angeordnet, dass die maximale lokale Feldstärke, welcher der LTS-Draht im Betrieb ausgesetzt ist, 23,5T beträgt. Bei 23,5T erreicht man mit Nb3Sn-Material gerade noch eine vernünftig hohe Stromdichte. Wenn man die Feldformelemente also bis maximal 23,5T einsetzt, nützt man die Eigenschaften des LTS-Leiters ideal aus.

Vorteilhaft ist auch eine Klasse von Weiterbildungen, bei denen die Feldformelemente in einem Bereich angeordnet sind, in welchem der Feldwinkel des von der Magnetspulenanordnung erzeugten Magnetfelds bezüglich der Axialrichtung des Magnetfelds besonders groß ist, insbesondere zwischen 10° und 15°, der absolute Betrag des Magnetfelds in diesem Bereich aber unterhalb des kritischen Felds des eingesetzten LTS-Leitermaterials liegt. Bei Feldwinkeln zwischen 10 und 15° leidet die Stromtragfähigkeit von HTS-Bandleitern schon merklich. Wenn in diesem Bereich LTS statt HTS Material eingesetzt werden kann, ist das deshalb sehr hilfreich.

In der Praxis bewähren sich auch Ausführungsformen der erfindungsgemäßen Spulenanordnung, bei welchen das Verhältnis der axialen Länge der LTS-Feldformelemente zur axialen Länge der jeweils benachbarten HTS-Spulensektion zwischen 1:3 und 1:8, vorzugsweise etwa 1:5, beträgt. Simulationen haben ergeben, dass dieses Längenverhältnis in Hochfeldmagneten zu einem besonders effizienten Design führt.

Von großem praktischem Vorteil sind auch Ausführungsformen, die sich dadurch auszeichnen, dass die LTS-Feldformelemente ungefähr die gleichen Innen- und Außendurchmesser aufweisen wie die jeweilige die HTS-Spulensektion, an die sie axial angrenzen. Im Magnetdesign ist es wichtig, alles vorhandene Volumen mit stromdurchflossenem Leiter auszufüllen - Leerräume sind aus Designsicht eher ineffizient. Wenn also die LTS-Feldformelemente und die HTS-Sektionen gleiche Durchmesser haben, können etwa LTS-HTS-LTS Stacks leicht ineinander bzw. leicht in andere Spulensektionen gesteckt werden, ohne dass es Leerräume gibt.

Bei weiteren vorteilhaften Ausführungsformen sind mindestens zwei benachbart angeordnete Stacks mit alternierenden LTS-HTS-LTS-Leitern vorhanden, wobei die Stacks in der Weise elektrisch miteinander verbunden sind, dass eine Stromführung von einem ersten LTS-HTS-LTS-Stack und dann zurück durch einen benachbarten LTS-HTS-LTS Stack verläuft. So wird die Leiterführung im Magneten besonders einfach. Üblicherweise achtet man darauf, dass in einer Solenoidwicklung der Stromein- und -ausgang auf derselben Seite des Solenoids zu liegen kommen. In einer normalen Wicklung erreicht man das durch eine gerade Langenzahl (2, 4, 6, etc). Bei einem Stack ist das gerade *nicht* möglich. Der Strom wird daher innerhalb des Stacks nach unten geführt, und muss dann außerhalb des Stacks wieder nach oben geführt werden. Wenn zwei LTS-HTS-LTS Stacks verbaut werden, kann der Strom im ersten Stack von oben nach unten, und im zweiten Stack von unten nach oben geführt werden. Das würde man normalerweise nicht so machen. Wie oben erläutert, sitzen üblicherweise Stromeingang und -ausgang beide an der Oberseite einer Spulensektion. Damit vereinfacht sich die Arbeit zur Verbindung der Magnetsektionen untereinander. Wenn allerdings ein LTS-HTS-LTS Stack verwendet wird, ergeben sich aus so einer Stromführung neue Vorteile, die die kompliziertere Verbindung der Sektionen aufwiegen. Nämlich: Man muss sich nicht darum sorgen, wie Strom aus dem unteren LTS Paket wieder nach oben geführt wird - man macht einfach einen Joint zu einem benachbarten LTS-HTS-LTS Stack, und führt den Strom in diesem Stack nach oben.

In den Rahmen der vorliegenden Erfindung fällt auch ein Verfahren zur Herstellung einer erfindungsgemäßen Magnetspulenanordnung der oben beschriebenen Art, welches folgende Verfahrensschritte umfasst:
i) Wickeln der Feldformelemente aus LTS-Halbzeug enthaltend ein Gemisch aus Nb und Sn,
ii) Reagieren von Nb und Sn zum fertigen LTS-Draht durch Erhitzen des gewickelten LTS-Halbzeugs auf eine Temperatur >520°C,
iii) Verlöten eines inneren Endes des LTS-Drahts eines ersten Feldformelements mit dem ersten Ende des HTS Bandleiters (Joint 4a),
iv) Wickeln der HTS Spulensektion, und
v) Verlöten des äußeren Endes des LTS-Drahts des zweiten Feldformelements mit dem äußeren Ende des HTS Bandleiters (Joint 4b).

So lässt sich ein LTS-HTS-LTS Stack auf erstaunlich einfache Art fertigen, wobei als LTS-Material hier Nb3Sn zum Einsatz kommt. Bei Nb3Sn ist erschwerend, dass der Leiter bei Temperaturen "reagiert" werden muss, bei denen der HTS-Leiter beschädigt wird. Es musste also ein Verfahren gefunden werden, welches es erlaubt, den Nb3Sn Leiter zuerst zu wickeln und zu reagieren, und erst danach den LTS Leiter zu wickeln und elektrisch zu verbinden.

Der Vorteil dieses Verfahrens besteht auch darin, dass es zu einem Spulendesign führt, welches eine erhöhte Stromtragfähigkeit aufweist, und dass die Spule für den Betrieb bei einer gegebenen Magnetfeldstärke eine insgesamt geringere Supraleiterqualität oder -menge benötigt als für die Ausgangsspule.

Schließlich fällt in den Rahmen der vorliegenden Erfindung auch ein Magnetresonanz-Spektrometer mit einer Magnetspulenanordnung der der oben beschriebenen erfindungsgemäßen Art.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1a: eine schematische Schnitt-Darstellung durch eine erste Ausführungsform der erfindungsgemäßen Magnetspulenanordnung in einer die Axialrichtung enthaltenden Ebene mit der relativen geometrischen Anordnung der Spulenbereiche (aus Symmetriegründen ist nur eine Hälfte der Spule dargestellt);
- Fig. 1b: eine weitere Ausführungsform der erfindungsgemäßen Magnetspulenanordnung mit mehreren, in radialer Richtung aufeinanderfolgenden Stacks, die jeweils in Axialrichtung alternierend aus einem Feldformelement, einer HTS-Spulensektion sowie einem weiteren Feldformelement aufgebaut sind;
- Fig. 2a: eine schematische Schnittdarstellung einer weiteren Ausführungsform der erfindungsgemäßen Magnetspulenanordnung, wobei die Anordnung einen Stack mit in Axialrichtung alternierenden LTS-HTS-LTS-Leitern bildet;
- Fig. 2b: eine Ausführungsform mit zwei benachbart angeordneten, elektrisch miteinander verschalteten Stacks wie in Fig. 2a dargestellt;
- Fig. 3a: den Feldverlauf entlang der z-Achse eines typischen NMR Hochfeldmagnets nach dem Stand der Technik mit einer beispielhaften Spulenlänge in der inneren Sektion von ca. 50cm;
- Fig. 3b: die Abhängigkeit des kritischen Stroms I_{C} vom Hintergrundfeld für den Magnetfeldwinkel 0° (Feldlinien parallel zur HTS-Bandoberfläche) und 15°, normiert auf die maximale Stromtragfähigkeit des Bandes I₀ bei B = 0 und einem Winkel von 0°; und
- Fig. 3c: die Form einer beispielhaften Feldlinie bei einer herkömmlichen Magnetspulenanordnung nach dem Stand der Technik, wobei zum Randbereich der HTS-Sektion hin die Radialkomponente des Felds deutlich zunimmt.

Um die Funktionsweise der vorliegenden Erfindung sowie die in deren Umfeld auftretenden, mit der Erfindung behebbaren technischen Probleme zu veranschaulichen, sollen zunächst die zugrunde liegenden physikalischen Prinzipien erläutert werden:

Der Feldverlauf entlang der Axialrichtung (z) eines typischen NMR Hochfeldmagnets nach dem Stand der Technik mit einer beispielhaften Spulenlänge in der inneren Sektion von ca. 50cm ist in Fig. 3a gezeigt: Außerhalb des homogenen Plateaus fällt das Feld stark ab. Schon bei einer Position 25cm oberhalb und unterhalb des magnetischen Zentrums ist das Feld auf ca. die Hälfe seines Maximalwerts gefallen. Das bedeutet, dass bei einem maximalen Feld von 28T im magnetischen Zentrum der 80%-Wert 22,4T beträgt, also ein Wert, bei welchem ein üblicher Nb3Sn Leiter noch eine ausreichende Stromtragfähigkeit hat.

Die Abhängigkeit des kritischen Stroms I_{C} vom Hintergrundmagnetfeld ist in Fig. 3b exemplarisch für zwei verschiedene Feldwinkel (15° und 0° = Feldlinien verlaufen parallel zur HTS-Bandoberfläche) dargestellt, normiert auf die maximale Stromtragfähigkeit des Bandes I₀ bei B = 0 und einem Winkel von 0°.

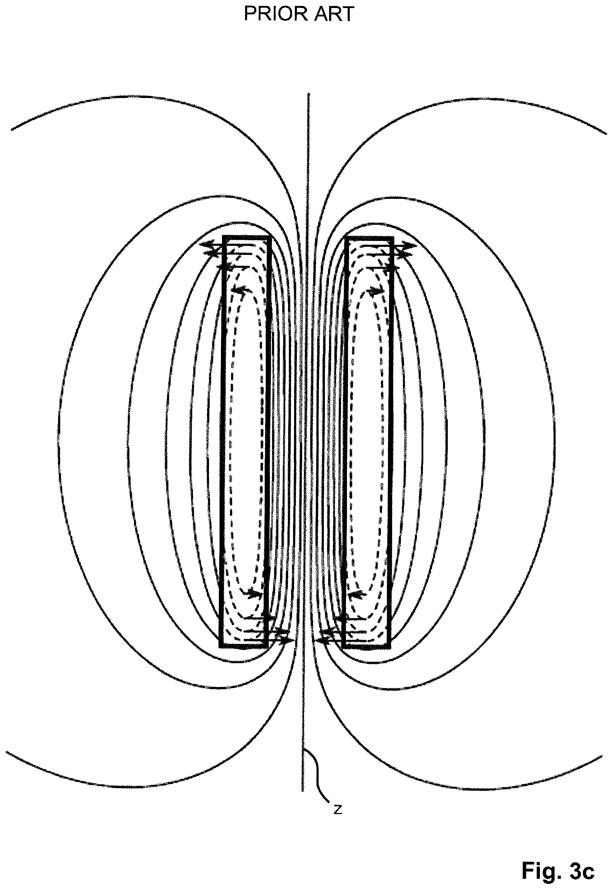

In Fig. 3c ist die Form einer beispielhaften Feldlinie bei einer herkömmlichen Magnetspulenanordnung nach dem Stand der Technik gezeigt, wobei zum Randbereich der HTS-Sektion hin die Radialkomponente des Felds deutlich zunimmt. Die Magnetspulenanordnung kann in ihrem bezüglich der **Axialrichtung z** radial äußeren Teil eine oder mehrere **Spulenwicklungen** mit üblichem LTS-Draht aufweisen, dadurch würde sich der Feldlinienverlauf geringfügig ändern. Es ist in Fig. 3c gut zu erkennen, dass die Radialkomponenten der Feldlinien im Randbereich der HTS-Spule deutlich zunehmen.

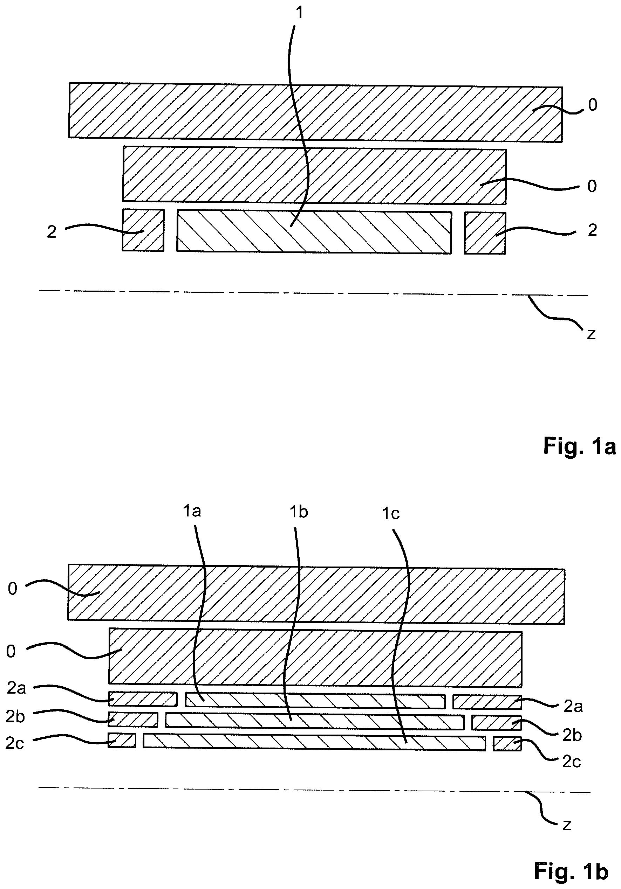

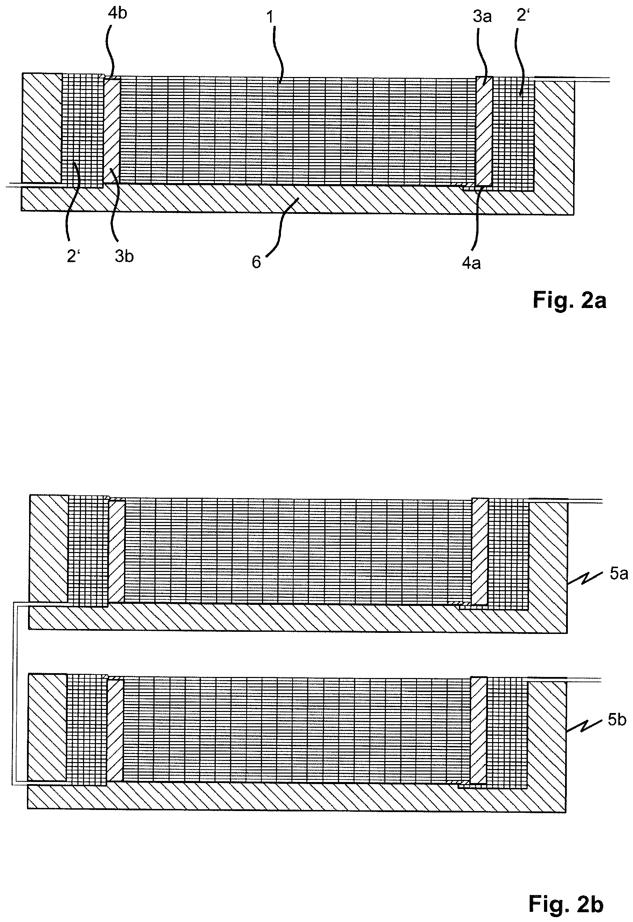

Die in den **Figuren 1a, 1b****,** **2a und 2b** schematisch dargestellten Ausführungsformen der erfindungsgemäßen Magnetspulenanordnung sind ebenfalls jeweils längs einer Axialrichtung z aufgebaut und umfassen mindestens eine solenoidförmigen **HTS-Spulensektion 1; 1a,1b,1c.** Außerdem ist jeweils eine mindestens zwei **Feldformelemente 2; 2a,2b,2c** umfassende Feldformvorrichtung vorgesehen.

Die erfindungsgemäße Magnetspulenanordnung zeichnet sich dadurch aus, dass jeweils mindestens ein Feldformelement 2; 2a,2b,2c an die beiden axialen Enden der HTS-Spulensektion 1; 1a, 1b, 1c angrenzend angeordnet ist, wobei die Feldformelemente 2; 2a,2b,2c derart ausgestaltet sind, dass sie den Feldwinkel des von der Magnetspulenanordnung erzeugten Magnetfelds bezüglich der Axialrichtung im Bereich der HTS-Spulensektion 1; 1a,1b,1c um mindestens 1,5° verkleinern. Dabei enthalten die Feldformelemente 2; 2a,2b,2c eine oder mehrere mit einem Tieftemperatursupraleiter-Draht gewickelte **LTS-Spulensektionen 2',** welche mit den HTS-Spulensektionen 1; 1a, 1b,1c elektrisch verbunden, insbesondere in Serie geschaltet sind, wobei jeweils der HTS-Bandleiter und der LTS-Draht durch einen **Joint 4a, 4b** miteinander verbunden sind. Die HTS-Spulensektionen 1; 1a,1b,1c können von den Feldformelementen 2; 2a,2b,2c in axialer Richtung durch einen oder mehrere **Flansche 3a, 3b** räumlich getrennt angeordnet sein.

Während Fig. 1a eine besonders einfache Ausführungsform der erfindungsgemäßen Magnetspulenanordnung zeigt, ist in Fig. 1b eine weitere Ausführungsform dargestellt, welche mehrere, in radialer Richtung aufeinanderfolgende Einheiten aufweist, die jeweils in Axialrichtung alternierend aus einem Feldformelement 2a,2b,2c, einer HTS-Spulensektion 1a,1b,1c sowie einem weiteren Feldformelement 2a,2b,2c aufgebaut sind.

Fig. 2a zeigt eine weitere Ausführungsform der erfindungsgemäßen Magnetspulenanordnung, bei die HTS-Spulensektion 1 mit den in axialer Richtung jeweils angrenzenden, durch Flansche 3a, 3b räumlich getrennte, aber mittels Joints 4a, 4b elektrisch verbundene LTS-Feldformelemente 2' auf einem gemeinsamen **Spulenkörper 6** aufgewickelt sind. Die Anordnung bildet also einen Stack mit in Axialrichtung alternierenden LTS-HTS-LTS-Leitern.

In Fig. 2b schließlich ist eine Ausführungsform mit zwei benachbart angeordneten, elektrisch miteinander verschalteten **Stacks 5a, 5b** dargestellt, welche dieselbe Struktur aufweisen, wie die Anordnung in Fig. 2a.

Nach dem oben beschriebenen erfindungsgemäßen Prinzip ist eine Vielzahl von Konfigurationen möglich, zum Beispiel auch eine, in der die Feldformspulen dort länger ausgeführt werden, wo die Feldwinkel höher sind (typischerweise in den äußeren HTS Sektion) und kürzer, wo das Hintergrundfeld höher ist (typischerweise in den inneren HTS Sektionen):
Die HTS Sektion kann mit den LTS "Feldformspulen" auch direkt elektrisch verbunden werden, so dass die HTS Stromzuführungen zur HTS Sektion entfallen können.

Da die HTS Sektion sehr kleinen radialen Feldkomponenten ausgesetzt ist, bauen sich nur sehr schwache Abschirmströme auf, und die Homogenität des Magnets verbessert sich.

Das LTS-Material Nb₃Sn, das im Magnetbau oft eingesetzt wird, muss nach dem Aufwickeln des Leiters auf den Spulenkörper temperaturbehandelt werden. Diese Temperaturbehandlung findet bei > 520°C statt. Da HTS Leiter solchen Temperaturen nicht standhalten können, muss die Spulensektion dann so konstruiert werden, dass zuerst der Nb₃Sn Leiter auf den Spulenkörper 6 in die zwei dafür vorgesehenen Kammern gewickelt werden kann, wonach die Temperaturbehandlung erfolgt. Der HTS Leiter wird nach der Temperaturbehandlung auf den Spulenkörper gewickelt, und kann zum Beispiel mit dem Nb₃Sn Leiter verbunden werden.

Auch mehrere auf solche Art gefertigte Spulensektionen können zu einem Magnetsystem verschaltet werden.

Werden für die Feldformspulen Nb3Sn Leiter eingesetzt, werden die Feldformspulen bevorzugt axial so weit an das magnetische Zentrum herangezogen, bis die maximale lokale Feldstärke, der der Nb3Sn Leiter ausgesetzt ist, 22,5T beträgt. Dies garantiert, dass im Nb3Sn Leiter noch ausreichend hohe Stromtragfähigkeit vorhanden ist. Im vorliegenden Beispiel nach Fig. 3a läge der Abstand der Feldformspule zum magnetischen Zentrum bei etwa 17cm.

Der maximale Feldwinkel in diesem Bereich, also bei der radial innersten Wicklung an den axial äußeren Enden der Spule, liegt -je nach Magnetdesigntypischerweise zwischen 5 und 15 Grad. Durch die Feldformelemente lässt sich der Feldwinkel im HTS Bereich um typischerweise 2 bis 4 Grad verringern, was die Stromauslastung des HTS Leiters (I/Ic) um mindestens 20 Prozent verringert. Gleichzeitig verbessert sich durch die Reduktion der Abschirmströme die Homogenität des Magnets um etwa 25%.

Typischerweise haben die Feldformspulen ungefähr den gleichen Innen- und Außendurchmesser wie das HTS Wickelpaket, das sie umgeben, denn man zielt darauf ab, möglichst das gesamte freie Volumen zu Magnetwicklungen zu verwenden um die Feldstärke zu maximieren. Im Falle eines UHF NMR Magneten der derzeitigen Generation beträgt bei einer Standardbore-Ausführung der Innendurchmesser des HTS Wickelpakets etwa 80mm, der Außendurchmesser etwa 160mm und bei einer Widebore-Ausführung der Innendurchmesser etwa 115mm, der Außendurchmesser etwa 180mm.

Das Längenverhältnis eines Feldformelementes zur HTS Spule beträgt in der inneren Sektion etwa 1:5; die Feldformelemente der äußeren Sektionen können auch länger ausgeführt sein, da dort das Magnetfeld geringer ist und somit die Stromtragfähigkeit im LTS noch gegeben ist.

Wie bereits oben erwähnt, können die Feldformspulen und das HTS Wickelpaket in Axialrichtung durch Flansche 3a, 3b räumlich voneinander getrennt werden. Ein Flansch ist eine fest mit dem Spulenkörper 6 verbundene umlaufende Verstärkungsscheibe. Diese Flansche nehmen zumindest teilweise den zum magnetischen Zentrum gerichteten axialen Druck auf, der in den Nb3Sn Wickelpaketen entsteht (typischerweise zwischen 5 und 15MPa). Es gilt normalerweise, möglichst jeden Druck auf die HTS-Wicklung zu vermeiden. Die Flansche haben bevorzugt eine Dicke zwischen 2 und 10mm. Ist die Dicke kleiner als 2mm, ist der Flansch zu schwach um dem Druck der Feldformelemente zu widerstehen. Ist der Flansch >10mm, ist der Spalt zwischen den Wicklungen so groß, dass magnetische Feldlinien durch den Spalt abknicken können, wodurch wiederum radiale Feldkomponenten auf die HTS Spule wirken können, was eigentlich vermieden werden soll.

Eine mögliche Verstimmung der Homogenität, die durch die Zinnspulen (Feldformelemente) hervorgerufen wird, kann durch geeignete Ausbildung des Notches oder durch Shims aus einem ferromagnetischen Material korrigiert werden. Diese Korrekturmöglichkeiten sind dem Fachmann per se bekannt.

Die radialen Feldkomponenten, die auf die HTS Sektion(en) wirken, können auch reduziert werden, indem die **LTS Sektionen 0** des Magneten ausreichend lang gestaltet werden. Dies wirkt sich allerdings negativ auf die Baugröße, die Masse und die Kosten des Magnets aus. Alternativ kann die HTS Sektion sehr kurz ausgeführt werden. Dann trägt sie allerdings weniger zum Feldhub bei, was den Magnet ineffizient macht. Außerdem wird so die Homogenisierung des Magnets deutlich erschwert.

Ein wesentlicher Vorteil der erfindungsgemäßen Anordnung besteht unter anderem in der gleichmäßigeren Verteilung der Stromtragfähigkeit des Supraleiters in der gesamten Spule. Dadurch wird der Supraleiter besser ausgenutzt und die Spule kann bei einem höheren Strom betrieben werden. Die benötigte Supraleiterqualität und -menge und damit die Materialkosten sind geringer bzw. mit derselben Supraleitermenge kann ein höheres Magnetfeld im Spulenzentrum erzeugt werden.

Die vorliegende Erfindung kommt prinzipiell für alle Magnetsysteme mit Spulen aus HTS-Material in Frage. Ein Einsatz bei Systemen mit LTS-Spulen als Feldformelementen ist allerdings nur bei Systemen sinnvoll, deren Betriebstemperatur (T < 10K) so gewählt ist, dass sowohl HTS- als auch LTS-Leiter eingesetzt werden können.

### Bezugszeichenliste:

- 0: radial äußere Magnetspulenwicklungen aus LTS-Draht
- 1; 1a; 1b; 1c: HTS-Spulensektion
- 2; 2a; 2b; 2c: Feldformelemente
- 2': LTS-Spulensektion
- 3a, 3b: Flansche
- 4a, 4b: Joints
- 5a, 5b: Stacks
- 6: Spulenkörper
- z: Symmetrieachse der Magnetspulenanordnung

## Patentansprüche

1. Längs einer Axialrichtung (z) aufgebaute supraleitfähige Magnetspulenanordnung mit mindestens einer solenoidförmigen Spulensektion (1; 1a,1b,1c), die mit einem HTS-, d.h. Hochtemperatursupraleiter-Bandleiter gewickelt ist, sowie mit einer mindestens zwei Feldformelemente (2; 2a,2b,2c) umfassenden Feldformvorrichtung, wobei jeweils mindestens ein Feldformelement (2; 2a,2b,2c) an die beiden axialen Enden der HTS-Spulensektion (1; 1a,1b,1c) axial angrenzend angeordnet ist, und wobei die Feldformelemente (2; 2a,2b,2c) derart ausgestaltet sind, dass sie den maximalen Feldwinkel des von der Magnetspulenanordnung erzeugten Magnetfelds bezüglich der Axialrichtung im Bereich der HTS-Spulensektion (1; 1a, 1b, 1c) um mindestens 1,5° verkleinern,
**dadurch gekennzeichnet,**
**dass** die Feldformvorrichtung Feldformelemente (2; 2a,2b,2c) umfasst, welche mindestens eine mit einem LTS-, d.h. Tieftemperatursupraleiterdraht gewickelte LTS-Spulensektion (2') enthalten.

2. Magnetspulenanordnung nach Anspruch 1, **dadurch gekennzeichnet, dass** das Längenverhältnis der HTS-Spulensektion (1; 1a,1b,1c) zu einem Feldformelement (2; 2a,2b,2c) zwischen 2:1 und 5:1 beträgt.

3. Magnetspulenanordnung nach einem der vorhergehenden Ansprüche, **dadurch gekennzeichnet, dass** die HTS-Spulensektion (1; 1a,1b,1c) von den Feldformelementen (2; 2a,2b,2c) durch einen oder mehrere Flansche (3a, 3b) räumlich getrennt ist, deren Dicke vorzugsweise zwischen 2mm und 10mm beträgt.

4. Magnetspulenanordnung nach einem der vorhergehenden Ansprüche, **dadurch gekennzeichnet, dass** die maximale Feldstärke am magnetischen Zentrum der Magnetspulenanordnung mindestens 27T und darüber, beträgt.

5. Magnetspulenanordnung nach einem der vorhergehenden Ansprüche, **dadurch gekennzeichnet, dass** die LTS-Spulensektionen (2') der Feldformvorrichtung mit den HTS-Spulensektionen (1; 1a,1b,1c) elektrisch verbunden, insbesondere in Serie geschaltet sind, wobei der HTS-Bandleiter und der LTS-Draht durch einen Joint (4a, 4b) verbunden sind.

6. Magnetspulenanordnung nach einem der vorhergehenden Ansprüche, **dadurch gekennzeichnet, dass** der LTS-Draht eine Legierung mit den Elementen Nb und Sn enthält.

7. Magnetspulenanordnung nach Anspruch 6, **dadurch gekennzeichnet, dass** die Feldformelemente (2; 2a,2b,2c) axial so nahe am magnetischen Zentrum der Magnetspulenanordnung angeordnet sind, dass die maximale lokale Feldstärke, der der LTS-Draht im Betrieb ausgesetzt ist, 23,5T beträgt.

8. Magnetspulenanordnung nach einem der vorhergehenden Ansprüche, **dadurch gekennzeichnet, dass** die Feldformelemente (2; 2a,2b,2c) in einem Bereich angeordnet sind, in welchem der Feldwinkel des von der Magnetspulenanordnung erzeugten Magnetfelds bezüglich der Axialrichtung des Magnetfelds größer als 5° ist, insbesondere zwischen 10° und 15°, der absolute Betrag des Magnetfelds in diesem Bereich aber unterhalb des kritischen Felds des eingesetzten LTS-Leitermaterials liegt.

9. Magnetspulenanordnung nach einem der vorhergehenden Ansprüche, **dadurch gekennzeichnet, dass** das Verhältnis der axialen Länge der Feldformelemente mit LTS-Spulensektionen (2') zur axialen Länge der jeweils benachbarten HTS-Spulensektion (1; 1a, 1b, 1c) zwischen 1:3 und 1:8, vorzugsweise etwa 1:5, beträgt.

10. Magnetspulenanordnung nach einem der vorhergehenden Ansprüche, **dadurch gekennzeichnet, dass** die LTS-Feldformelemente (2') ungefähr die gleichen Innen- und Außendurchmesser aufweisen wie die jeweilige die HTS-Spulensektion (1; 1a,1b,1c), an die sie angrenzen.

11. Magnetspulenanordnung nach einem der vorhergehenden Ansprüche, **dadurch gekennzeichnet, dass** mindestens zwei benachbart angeordnete Stacks (5a, 5b) mit alternierenden LTS-HTS-LTS-Leitern vorhanden sind, und dass die Stacks (5a, 5b) in der Weise elektrisch miteinander verbunden sind, dass eine Stromführung von einem ersten LTS-HTS-LTS-Stack (5a) und dann zurück durch einen benachbarten LTS-HTS-LTS Stack (5b) verläuft.

12. Magnetresonanz-Spektrometer mit einer Magnetspulenanordnung nach einem der vorhergehenden Ansprüche.

13. Verfahren zur Herstellung einer Magnetspulenanordnung nach einem der Ansprüche1 bis 11, umfassend die folgenden Verfahrensschritte:
i) Wickeln der Feldformelemente (2, 2a, 2b, 2c) aus LTS-Halbzeug enthaltend ein Gemisch aus Nb und Sn,
ii) Reagieren von Nb und Sn zum fertigen LTS-Draht durch Erhitzen des gewickelten LTS-Halbzeugs auf eine Temperatur >520°C,
iii) Verlöten eines inneren Endes des LTS-Drahts eines ersten Feldformelements mit dem ersten Ende des HTS Bandleiters,
iv) Wickeln der HTS Spulensektion (1, 1a, 1b, 1c), und
v) Verlöten des äußeren Endes des LTS-Drahts des zweiten Feldformelements mit dem äußeren Ende des HTS Bandleiters.

## Claims

1. A superconducting magnet coil arrangement built up along an axial direction (z) and having at least one coil section (1; 1a,1b,1c) in the form of a solenoid that is wound with an HTS (high-temperature superconductor) tape conductor, and also having a field-shaping device comprising at least two field-shaping elements (2; 2a,2b,2c), wherein at least one field-shaping element (2; 2a,2b,2c) is arranged axially adjoining each of the two axial ends of the HTS coil section (1; 1a,1b,1c), and wherein the field-shaping elements (2; 2a,2b,2c) are configured in such a way that they reduce the maximum field angle of the magnetic field generated by the magnet coil arrangement with respect to the axial direction in the region of the HTS coil section (1; 1a, 1b, 1c) by at least 1.5°,
**characterized in that**
the field-shaping device comprises field-shaping elements (2; 2a,2b,2c) that contain at least one LTS coil section (2') wound with an LTS (low-temperature superconductor) wire.

2. The magnet coil arrangement as claimed in claim 1, **characterized in that** the length ratio of the HTS coil section (1; 1a,1b,1c) to a field-shaping element (2; 2a,2b,2c) is between 2:1 and 5:1.

3. The magnet coil arrangement as claimed in one of the preceding claims,
**characterized in that** the HTS coil section (1; 1a,1b,1c) is spatially separated from the field-shaping elements (2; 2a,2b,2c) by one or more flanges (3a, 3b), the thickness of which is preferably between 2 mm and 10 mm.

4. The magnet coil arrangement as claimed in one of the preceding claims,
**characterized in that** the maximum field strength at the magnetic center of the magnet coil arrangement is at least 27 T and above.

5. The magnet coil arrangement as claimed in one of the preceding claims,
**characterized in that** the LTS coil sections (2') of the field-shaping device are electrically connected to the HTS coil sections (1; 1a,1b,1c), in particular connected in series, the HTS tape conductor and the LTS wire being connected to one another by a joint (4a, 4b).

6. The magnet coil arrangement as claimed in one of the preceding claims, **characterized in that** the LTS wire contains an alloy with the elements Nb and Sn.

7. The magnet coil arrangement as claimed in claim 6, **characterized in that** the field-shaping elements (2; 2a,2b,2c) are arranged axially so close to the magnetic center of the magnet coil arrangement that the maximum local field strength to which the LTS wire is exposed during operation is 23.5 T.

8. The magnet coil arrangement as claimed in one of the preceding claims,
**characterized in that** the field-shaping elements (2; 2a,2b,2c) are arranged in a region in which the field angle of the magnetic field generated by the magnet coil arrangement with respect to the axial direction of the magnetic field is greater than 5°, in particular between 10° and 15°, but the absolute amount of the magnetic field in this region lies below the critical field of the LTS conductor material used.

9. The magnet coil arrangement as claimed in one of the preceding claims, **characterized in that** the ratio of the axial length of the field-shaping elements with LTS coil sections (2') to the axial length of the respectively adjacent HTS coil section (1; 1a,1b,1c) is between 1:3 and 1:8, preferably approximately 1:5.

10. The magnet coil arrangement as claimed in one of the preceding claims,
**characterized in that** the LTS field-shaping elements (2') have approximately the same inside and outside diameters as the respective HTS coil section (1; 1a,1b,1c) to which they adjoin.

11. The magnet coil arrangement as claimed in one of the preceding claims, **characterized in that** there are at least two adjacently arranged stacks (5a, 5b) with alternating LTS-HTS-LTS conductors, and **in that** the stacks (5a, 5b) are electrically connected to one another in such a way that there is a current conduction from a first LTS-HTS-LTS stack (5a) and then back through an adjacent LTS-HTS-LTS stack (5b).

12. A magnetic resonance spectrometer with a magnet coil arrangement as claimed in one of the preceding claims.

13. A method for producing a magnet coil arrangement as claimed in one of the claims 1 to 11, comprising the following method steps:
i) winding the field-shaping elements (2, 2a, 2b, 2c) from LTS semifinished material containing a mixture of Nb and Sn,
ii) reacting Nb and Sn to form the finished LTS wire by heating the wound LTS semifinished material to a temperature of > 520°C,
iii) soldering an inner end of the LTS wire of a first field-shaping element to the first end of the HTS tape conductor,
iv) winding the HTS coil section (1, 1a, 1b, 1c), and
v) soldering the outer end of the LTS wire of the second field-shaping element to the outer end of the HTS tape conductor.

## Revendications

1. Agencement de bobine magnétique supraconductrice construit suivant une direction axiale (z), comportant au moins une section de bobine (1 ; 1a, 1b, 1c) en forme de solénoïde qui est enroulée avec un conducteur en ruban HTS, c'est-à-dire supraconducteur à haute température, et comportant un dispositif de mise en forme de champ comprenant au moins deux éléments de mise en forme de champ (2 ; 2a, 2b, 2c), au moins un élément de mise en forme de champ (2 ; 2a, 2b, 2c) étant disposé de manière axialement adjacente à chacune des deux extrémités axiales de la section de bobine HTS (1 ; 1a, 1b, 1c), et les éléments de mise en forme de champ (2 ; 2a, 2b, 2c) étant conçus de telle sorte qu'ils réduisent d'au moins 1,5° l'angle de champ maximal du champ magnétique produit par l'agencement de bobine magnétique par rapport à la direction axiale dans la zone de la section de bobine HTS (1 ; 1a, 1b, 1c),
**caractérisé en ce**
**que** le dispositif de mise en forme de champ comprend des éléments de mise en forme de champ (2 ; 2a, 2b, 2c) qui contiennent au moins une section de bobine LTS (2') enroulée avec un fil LTS, c'est-à-dire supraconducteur à basse température.

2. Agencement de bobine magnétique selon la revendication 1, **caractérisé en ce que** le rapport de longueur entre la section de bobine HTS (1 ; 1a, 1b, 1c) et un élément de mise en forme de champ (2 ; 2a, 2b, 2c) est compris entre 2:1 et 5:1.

3. Agencement de bobine magnétique selon l'une des revendications précédentes,
**caractérisé en ce que** la section de bobine HTS (1 ; 1a, 1b, 1c) est séparée spatialement des éléments de mise en forme de champ (2 ; 2a, 2b, 2c) par une ou plusieurs brides (3a, 3b) dont l'épaisseur est de préférence comprise entre 2 mm et 10 mm.

4. Agencement de bobine magnétique selon l'une des revendications précédentes,
**caractérisé en ce que** l'intensité de champ maximale au centre magnétique de l'agencement de bobine magnétique est d'au moins 27 T ou plus.

5. Agencement de bobine magnétique selon l'une des revendications précédentes,
**caractérisé en ce que** les sections de bobine LTS (2') du dispositif de mise en forme du champ sont reliées électriquement aux sections de bobine HTS (1 ; 1a, 1b, 1c), en particulier montées en série, le conducteur en ruban HTS et le fil LTS étant reliés par une jonction (4a, 4b).

6. Agencement de bobine magnétique selon l'une des revendications précédentes,
**caractérisé en ce que** le fil LTS contient un alliage avec les éléments Nb et Sn.

7. Agencement de bobine magnétique selon la revendication 6, **caractérisé en ce que** les éléments de mise en forme de champ (2 ; 2a, 2b, 2c) sont disposés axialement assez près du centre magnétique de l'agencement de bobine magnétique pour que l'intensité de champ locale maximale auquel le fil LTS est exposé en fonctionnement soit de 23,5 T.

8. Agencement de bobine magnétique selon l'une des revendications précédentes,
**caractérisé en ce que** les éléments de mise en forme de champ (2 ; 2a, 2b, 2c) sont disposés dans une zone dans laquelle l'angle de champ du champ magnétique produit par l'agencement de bobine magnétique par rapport à la direction axiale du champ magnétique est supérieur à 5°, en particulier compris entre 10° et 15°, mais la valeur absolue du champ magnétique dans cette zone est inférieure au champ critique du matériau de conducteur LTS utilisé.

9. Agencement de bobine magnétique selon l'une des revendications précédentes,
**caractérisé en ce que** le rapport de la longueur axiale des éléments de mise en forme de champ avec des sections de bobine LTS (2') sur la longueur axiale de la section de bobine HTS (1 ; 1a, 1b, 1c) respectivement adjacente est compris entre 1:3 et 1:8, de préférence d'environ 1:5.

10. Agencement de bobine magnétique selon l'une des revendications précédentes,
**caractérisé en ce que** les éléments de mise en forme de champ LTS (2') présentent approximativement les mêmes diamètres intérieur et extérieur que la section de bobine HTS respective (1 ; 1a, 1b, 1c) à laquelle ils sont adjacents.

11. Agencement de bobine magnétique selon l'une des revendications précédentes,
**caractérisé en ce qu'**au moins deux piles adjacentes (5a, 5b) avec des conducteurs LTS-HTS-LTS alternés sont prévues, et que les piles (5a, 5b) sont reliées électriquement entre elles de telle sorte qu'une conduction de courant a lieu à partir d'une première pile LTS-HTS-LTS (5a) puis en retour par une pile LTS-HTS-LTS adjacente (5b).

12. Spectromètre à résonance magnétique doté d'un agencement de bobine magnétique selon l'une des revendications précédentes.

13. Procédé de fabrication d'un agencement de bobine magnétique selon l'une des revendications 1 à 11, comprenant les étapes de procédé suivantes :
i) enroulement des éléments de mise en forme de champ (2, 2a, 2b, 2c) à partir d'un produit semi-fini LTS contenant un mélange de Nb et Sn,
ii) réaction de Nb et de Sn pour former un fil LTS fini par chauffage du produit semi-fini LTS enroulé à une température > 520 °C,
iii) soudage d'une extrémité intérieure du fil LTS d'un premier élément de mise en forme de champ avec la première extrémité du conducteur en ruban HTS,
iv) enroulement de la section de bobine HTS (1, 1a, 1b, 1c) ; et
v) soudage de l'extrémité extérieure du fil LTS du deuxième élément de mise en forme de champ avec l'extrémité extérieure du conducteur en ruban HTS.
